# EUROPEAN PATENT SPECIFICATION

(11) **EP 2 770 525 B1**
(45) Date of publication and mention of the grant of the patent: **07.12.2016**
(21) Application number: 12842007.2
(22) Date of filing: 11.10.2012
(51) Int. Cl.: H01L 21/02, H01L 27/12, H01L 21/762

(54) **METHOD FOR PRODUCING TRANSPARENT SOI WAFERS**
VERFAHREN ZUR HERSTELLUNG VON TRANSPARENTEN SOI-WAFERN
PROCÉDÉ DE FABRICATION DE TRANCHE TRANSPARENTE DE SILICIUM SUR ISOLANT

(30) Priority: 17.10.2011 JP 2011227962
(43) Date of publication of application: 27.08.2014
(73) Proprietor: Shin-Etsu Chemical Co., Ltd., Tokyo 100-0004 (JP)
(72) Inventor: AKIYAMA Shoji, Annaka-shi Gunma 379-0195 (JP); NAGATA Kazutoshi, Annaka-shi Gunma 379-0195 (JP)
(74) Representative: Vidon Brevets & Stratégie
(86) International application number: PCT/JP2012/076874
(87) International publication number: WO 2013/058292

(56) References cited:
- EP-A1- 2 352 164
- WO-A1-2007/069442
- JP-A- H01 313 923
- US-A1- 2004 206 444
- US-A1- 2010 248 414
- US-A1- 2011 230 005

## Description

### Field of the Invention

### Technical Field

The present invention relates to a method for producing a transparent SOI (Silicon-On-Insulator) wafer.

### Background of the Invention

### Background Art

SOI wafers have become widely used to reduce parasitic capacitance and speed up devices. Of SOI wafers, SOQ (Silicon-On-Quartz) and SOS (Silicon-On-Sapphire) have attracted attention as wafers comprising a transparent insulating wafer as a handle wafer.

SOQ wafers are expected to be applied to optoelectronics utilizing high transparency of quartz, or high-frequency devices utilizing low dielectric loss of quartz. SOS wafers are expected to be applied to high-frequency devices that involve heat generation, because the handle wafer made of sapphire has not only high transparency and low dielectric loss but also high thermal conductivity which is unattainable by quartz.

Methods of forming a silicon film onto a handle wafer have been developed and include: a method of heteroepitaxially growing a silicon layer on r-plane sapphire; and a method of growing non-single crystal silicon on glass and then enhancing crystallinity by laser annealing or the like to obtain CG (Continuous Grain) silicon.

However, in order to form a single crystal silicon film of high quality on a handle wafer, it is ideal to form the silicon film by a method in which a bulk silicon wafer is bonded to a handle wafer and a part of the silicon wafer is detached to be transferred onto the handle wafer. When the transferred silicon film is thin (e.g. less than 500 nm), it is possible to detach and transfer the silicon film for transferring by a hydrogen ion implantation method (Patent Document 1).

### Prior art document

### Patent document

Patent Document 1: WO 2009/116664 A

The document US2011/230005 (published 22/09/2011) relates to a process for fabricating a multilayer structure that includes bonding a first wafer onto a second wafer, where the first wafer may have a chamfered edge and the bonding interface has an adhesion energy of less than or equal to 1 J/m2, and thinning the first wafer so as to form a transferred layer, where before thinning the first wafer, a step of trimming the edge of the first wafer is carried out using a grinding wheel having a working surface which comprises grit particles with an average size of greater than or equal to 800 mesh or less than or equal to 18 microns, and wherein the trimming step is carried out by lowering the grinding wheel at a rate of descent of greater than or equal to 5 microns per second, such that the descent of the grinding wheel into the first wafer continues to a distance from the bonding interface that is less than or equal to 30 [mu]m.

### Summary of the Invention

### Problems to be solved by the Invention

However, when the silicon film to be transferred is thick (e.g. greater than 1 µm), there is no other method than the conventional bonding-and-etch-back method. To implant ions deeply, it is necessary to increase the acceleration voltage during implanting ions. Implanting ions with the increased acceleration voltage, however, has a risk of damaging the surface of the silicon film.

The bonding-and-etch-back method is a method in which, after bonding two wafers (a donor wafer and a handle wafer) are bonded together and heat-treated to enhance the bonding strength, and then the back of the donor wafer is ground or polished to make the donor wafer thinner, thus forming a silicon film of a desired thickness. Regarding bonding of the two wafers, the wafers cannot be bonded in an area (edge exclusion) within several mm from the wafer periphery. This is because the edges of the wafers are rounded as a result of the wafers having undergone a process called chamfering.

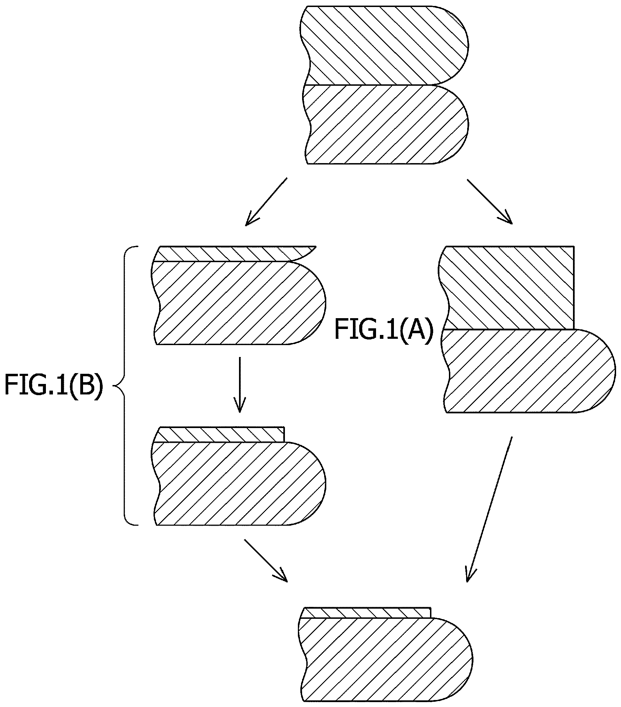

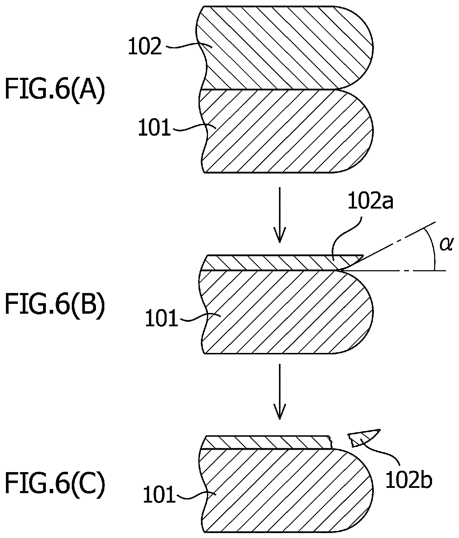

FIG. 6 is a schematic drawing showing chipping that occurs in a simple thin film formation process. Two wafers (a donor wafer 102 and a handle wafer 101) are bonded (FIG. 6(A)) and then heat-treated. When the donor wafer 102 is ground or polished to the thickness of several µm (in FIG. 6(B)), a breakage 102b called chipping occurs frequently because an angle α of a cross section 102a of the periphery of the donor wafer is acute (in FIG. 6 (C)). To prevent this, the present inventors have found a method of mechanically scraping off the periphery beforehand (in FIG. 1 (A)) or removing the periphery by a chemical or the like (in FIG. 1 (B)), as shown in FIG. 1. However, such a method cannot be employed between wafers that differ in the coefficient of thermal expansion, for the following reason. In the case of an SOQ wafer and an SOS wafer in which the coefficients of thermal expansion of the donor wafer and the handle wafer are significantly different, when a silicon wafer is bonded to quartz (glass) or sapphire and then heat-treated, the bonded wafer is damaged owing to the difference in the coefficient of thermal expansion. It is thus difficult to perform a sufficient heat treatment at the stage where the wafers are bonded. If the periphery of the wafer is mechanically or chemically removed at such a stage where only an insufficient heat treatment is possible, even a portion that should not be removed will end up being removed because the bonding strength is insufficient.

The present invention has been made in view of the above-mentioned circumstances, and provides a method for producing a transparent SOI wafer whereby wafer damage and chipping can be prevented.

### Solution to the Problem

To solve the problem stated above, the present inventors have discovered a method of utilizing the transparency of an SOQ wafer and an SOS wafer toward visible light.

In one aspect of the present invention, provided is a method for producing a transparent SOI wafer, the method comprising the steps of: bonding a surface of a silicon wafer used as a donor wafer and a surface of a transparent handle wafer together to obtain a bonded wafer; heat-heating the bonded wafer at a first temperature of 150 to 300°C as a first heat treatment; cutting off an unbonded portion of the bonded wafer along a boundary between the bonded surface and an unbonded circumferential surface by irradiating a visible light laser from a silicon wafer side of the heated bonded wafer to the boundary, while keeping an angle of 60 to 90° between an incident light of the laser and a radial direction of the silicon wafer; subjecting the silicon wafer of the bonded wafer having the unbonded portion cut off to grinding, polishing, or etching to form a silicon film; and heat-treating the bonded wafer having the silicon film formed at a second temperature of 300 to 500°C as a second heat treatment which is higher than the first temperature.

### Advantageous effect of the Invention

Wafer damage and chipping can be prevented by the method for producing a transparent SOI wafer according to the present invention.

### Brief Description of the Drawings

FIG. 1 is a schematic drawing showing a thin film formation process for an SOI wafer.
FIG. 2 is a schematic drawing showing an example of steps of a method for producing a transparent SOI wafer.
FIG. 3 is a top view of a bonded wafer.
FIG. 4 is an enlarged photograph of the periphery of a transparent SOI wafer obtained in Example 3.
FIG. 5 is an enlarged photograph of the periphery of a transparent SOI wafer obtained in Comparative Example 2.
FIG. 6 is a schematic drawing showing chipping that occurs in a simple film formation process.

### Description of Embodiments

A transparent handle wafer to be used in the present invention is preferably made of a material that is any of quartz, glass, and sapphire. The transparent handle wafer is preferably subjected to cleaning such as RCA cleaning, before the below-mentioned bonding step.

A donor wafer to be used in the present invention includes a single crystal silicon wafer such as the donor wafer is a commercially available wafer produced by the Czochralski method. The electrical characteristics such as the conductivity type and the relative resistivity, the crystal orientation, and the crystal size of the donor wafer may be appropriately selected depending on the design values and the process of device in which transparent SOI wafers produced by the method according to the present invention is used, the display areas of produced devices, and so on.

The thickness of the silicon wafer may be appropriately selected depending on a desired thickness of the silicon film described later, and is not particularly limited. For example, a 6-inch silicon wafer having 550 to 650 µm in thickness and an 8-inch silicon wafer having 650 to 750 µm in thickness are easily available and also easy to handle.

The peripheral portion of the silicon wafer is chamfered, or the silicon wafer is preferably larger in diameter than the transparent handle wafer. In such a case, a bonded wafer has an unbonded portion (edge exclusion) of several mm from the wafer periphery. The chamfering method may include C chamfering and R chamfering.

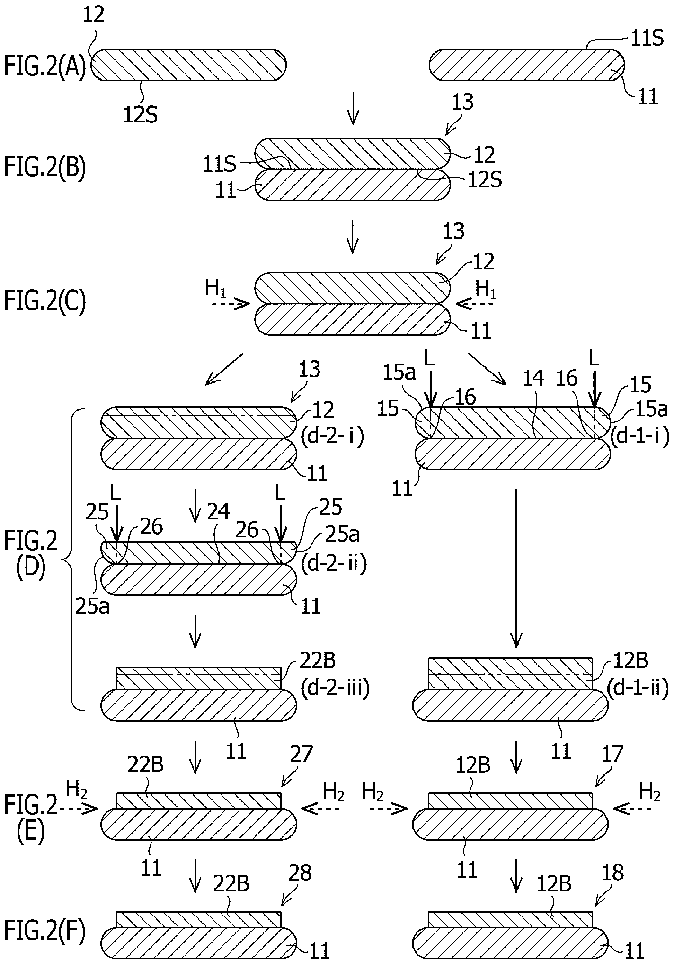

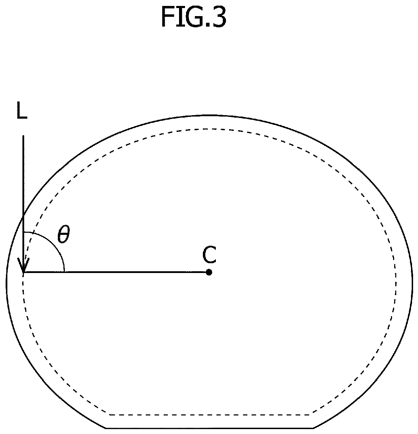

The following describes a method for producing a transparent SOI wafer according to the present invention with reference to FIG. 2 and FIG. 3. However, it should not be construed that the present invention is limited to or by them.

### (First Embodiment)

FIG. 2 is a schematic drawing showing embodiments of a method for producing a transparent SOI wafer.

As shown in FIG. 2 (A), a transparent handle wafer 11 and a silicon wafer 12 as a donor wafer are provided. Next, as shown in FIG. 2 (B), a surface 12s of the silicon wafer 12 and a surface 11s of the transparent handle wafer 11 are bonded together to obtain a bonded wafer 13.

A silicon wafer having an oxide film formed on the surface 12s or the whole surfaces may be optionally used as the donor wafer. The oxide film can be formed by a typical thermal oxidation method. The oxide film is typically obtained by a heat treatment at 800 to 1100°C under normal pressure in an oxygen atmosphere or a water-vapor atmosphere. The thickness of the oxide film is preferably 50 to 500 nm. When the oxide film is too thin, it may be difficult to control the thickness of the oxide film. When the oxide film is too thick, it may take too long to form the oxide film.

Before the step of bonding the surface 12s and the surface 11s, a step of a surface activation treatment may be performed on either or both of the surface of the silicon wafer 12 and the surface of the transparent handle wafer 11. The surface activation treatment can contribute to higher bonding strength between the bonded surfaces of the bonded wafer immediately after bonding.

The surface activation treatment is preferably at least one selected from the group consisting of an ozone water treatment, an UV ozone treatment, an ion beam treatment and a plasma treatment.

In the plasma treatment, for example, the silicon wafer and/or the transparent handle wafer subjected to cleaning such as RCA cleaning is placed in a chamber. Then, after a plasma gas under reduced pressure is introduced into the chamber, the silicon wafer and/or the transparent handle wafer is exposed to high-frequency plasma of about 100 W for about 5 to 10 seconds, thereby plasma-treating the surface. When the silicon wafer is plasma-treated with surface oxidation, the plasma gas may be oxygen gas. When the silicon wafer is plasma-treated without the surface oxidization, the plasma gas may be hydrogen gas, argon gas, nitrogen gas, a mixture of two or more of these gases, or a mixture of hydrogen gas and helium gas. When the transparent handle wafer is plasma-treated, any gas may be used. As a result of the plasma treatment, organic matter on the surface of the silicon wafer and/or the transparent handle wafer is oxidized and removed, and also the surface is activated because of increase of OH groups.

The ozone water treatment can be performed, for example, by immersing the wafer in pure water in which about 10 mg/L ozone is dissolved.

The UV ozone treatment can be performed by irradiating ozone gas or ozone gas generated from an atmosphere with UV light (e.g. 185 nm in wavelength).

The ion beam treatment can be performed, for example, by treating the surface of the wafer with a beam of an inert gas such as argon under high vacuum as in sputtering, to expose dangling bonds on the surface and increase the bonding force.

In the ozone water treatment, the UV ozone treatment and the like, organic matter on the surface of the silicon wafer or the transparent handle wafer is decomposed by ozone so that the surface is increased in OH group, thereby activating the surface. In the ion beam treatment, the plasma treatment and the like, highly reactive uncombined hands (dangling bonds) on the surface of the wafer are exposed or OH group is added to the uncombined hands, thus activating the surface.

The surface activation can be confirmed by checking the degree of hydrophilicity (wettability). In detail, the surface activation can be easily measured by dropping water on the surface of the wafer and measuring its contact angle.

As shown in FIG. 2 (C), a first heat treatment H₁ at 150 to 300°C is performed on the bonded wafer 13. For example, the first heat treatment H₁ preferably at 150 to 300°C is performed when quartz or glass is used as the transparent handle wafer 11. The first heat treatment H₁ preferably at 150 to 250°C is performed when sapphire is used as the transparent handle wafer 11. The heat treatment time is determined according to the heat treatment temperature and the material, and is preferably selected from a range of 1 to 48 hours. By heat-treating the bonded wafer 13 in this way, it is possible to increase the bonding strength of the silicon wafer 12 and the transparent handle wafer 11. Moreover, the heat treatment at such a temperature has little risk of causing thermal strain, cracking, peeling, and the like due to the difference in thermal expansion coefficient between the wafers made of different materials. The bonding strength is already sufficient at this stage for the below-mentioned grinding or the like, but still not sufficient as the strength of a transparent SOI wafer.

The first heat treatment step is preferably performed in the presence of argon, nitrogen, helium, or a mixture of two or more of these gases.

As shown in FIG. 2 (D), an unbonded portion 15 of the bonded wafer is cut off by irradiating the visible light laser L from the silicon wafer side of the heat-treated bonded wafer to the boundary 16 between a bonded surface portion 14 bonded in the bonding step and an unbonded surface portion 15 a, while keeping an angle of 60 to 90° between the incident light and the radial direction of the silicon wafer (in step d-1-i).

FIG. 3 is a top view of the bonded wafer. In FIG. 3, the visible light laser L is applied to the boundary 16 between the bonded surface portion 14 and the unbonded surface portion 15a from the silicon wafer side of the heat-treated bonded wafer so that an angle θ between the incident light and the radial direction of the silicon wafer, i.e. an angle θ between the incident light and a line connecting the intersection of the incident light and the silicon wafer to a center C of the silicon wafer, is 60 to 90°, to cut off the unbonded portion 15. This method has no risk of causing damage and the like on the transparent handle wafer 11, even in the case where the visible light laser L, after cutting off the unbonded portion 15 of the silicon wafer, reaches the underlying transparent handle wafer 11.

The visible light laser is preferably a green laser, for example, a SHG-YAG laser (λ = 515 nm).

Regarding the angle of applying the visible light laser is such that the angle θ between the incident light and the radial direction of the silicon wafer is 60 to 90°. This makes the angle α where the angle α of the cross section 102a of the periphery of the silicon wafer is shown in FIG. 6 (B). Consequently, a breakage called chipping is unlikely to occur. The θ is preferably 90°, that is, the incident light is preferably perpendicular to the bonded surface. Such an angle allows the diameter of the silicon film formed on the transparent handle wafer to be uniform regardless of the distance from the transparent handle wafer.

The silicon wafer 14 of the bonded wafer after cutting is subjected to treatment of grinding, polishing, or etching to form a silicon film 12B (in step d-1-ii). Such treatment after cutting off the above-mentioned unbonded portion 15, can prevent chipping. The silicon wafer is ground, polished, or etched until the silicon film reaches a desired thickness of, for example, about less than or equal to 20 µm.

As shown in FIG. 2 (E), a second heat treatment H₂ preferably at 300 to 500°C is performed on a bonded wafer 17 having the silicon film 12B. For example, when quartz or glass is used as the transparent handle wafer 11, the second heat treatment H₂ preferably at 350 to 500°C is performed. When sapphire is used as the transparent handle wafer 11, and the second heat treatment H₂ preferably at 300 to 500°C is performed. The second temperature of the second heat treatment H₂ can be set higher than the first temperature of the first heat treatment H₁. The second temperature of the second heat treatment H₂ is preferably 150 to 250°C higher than the first temperature of the first heat treatment H₁. Since the silicon film 12B is sufficiently thin at this stage, there is no risk of causing cracking and the like on the silicon film 12B even when the second heat treatment H₂ is performed.

A transparent SOI wafer 18 shown in FIG. 2(F) can be obtained as a result of the above-mentioned steps.

As described above, chipping can be prevented according to the first embodiment of the present invention.

### (Second Embodiment)

The steps in FIG. 2(A) to (C) are the same as those in the first embodiment. As in the first embodiment, the transparent handle wafer 11 and the silicon wafer 12 as a donor wafer are provided (in FIG. 2(A)), the surface 12s of the silicon wafer 12 and the surface 11s of the transparent handle wafer 11 are bonded together to obtain the bonded wafer 13 (FIG. 2(B)), and the heat treatment H₁ is performed on the bonded wafer 13 (FIG. 2(C)).

As shown in FIG. 2(D), the silicon wafer 12 of the bonded wafer 13 is subjected to grinding, polishing or etching before the below-mentioned cutting off step so that the silicon wafer 12 has preferably the thickness of greater than or equal to 100 µm (in step d-2-i). Such a thickness of the silicon wafer prevents chipping even with the acute angle α.

An unbonded portion 25 of the bonded wafer is cut off by radiating the visible light laser L from the silicon wafer side of the bonded wafer subjected to grinding, polishing or etching to a boundary 26 between a bonded surface portion 24 bonded in the bonding step and an unbonded surface portion 25a, while keeping an angle of 60 to 90° between the incident light and the radial direction of the silicon wafer (in step d-2-ii). This method has no risk of causing damage and the like on the transparent handle wafer 11, even in the case where the visible light laser L, after cutting off the unbonded portion 25 of the silicon wafer, reaches the underlying transparent handle wafer 11.

The silicon wafer 24 of the bonded wafer is subjected to treatment of grinding, polishing or etching after the step of cutting off so that the silicon wafer 24 has the thickness of less than or equal to 20 µm, to form a silicon film 22B (in step d-2-iii). Such treatment after cutting off the above-mentioned unbonded portion 25 can prevent chipping.

As shown in FIG. 2(E), the second heat treatment H₂ preferably at 300 to 500°C is performed on a bonded wafer 27 having the silicon film 22B, in the same manner as in the first embodiment. For example, the second heat treatment H₂ preferably at 350 to 500°C is performed when quartz or glass is used as the transparent handle wafer 11, and the second heat treatment H₂ preferably at 300 to 500°C is performed when sapphire is used as the transparent handle wafer 11. The second temperature of the second heat treatment H₂ can be set higher than the first temperature of the first heat treatment H₁. The second temperature of the second heat treatment H₂ is preferably 150 to 250°C higher than the first temperature of the first heat treatment H₁. Since the silicon film 22B is sufficiently thin at this stage, there is no risk of causing cracking and the like on the silicon film 22B even when the second heat treatment H₂ is performed.

A transparent SOI wafer 28 shown in FIG. 2(F) can be obtained as a result of the above-mentioned steps.

As described above, chipping can be prevented according to the second embodiment of the present invention.

Note that, even in the case where the silicon wafer and the transparent handle wafer differ in diameter, the transparent SOI wafer can be produced in the same way as in the first and second embodiments described above.

### Examples

The following describes the present invention in detail based on Examples and Comparative Examples. However, it should not be construed that the present invention is limited to or by Examples.

### (Example 1)

A silicon wafer of 150 mm in diameter and 625 µm in thickness and a quartz wafer of the same size as the silicon wafer were bonded together, and heat-treated at 200°C for 24 hours. Following this, the silicon wafer of the obtained bonded wafer was ground or polished to a thickness of 200 µm. A green laser (SHG-YAG laser: λ = 515 nm) was applied to the boundary between a bonded surface portion bonded in the bonding step and an unbonded surface portion, to vertically cut off an unbonded portion. Subsequently, the silicon wafer was ground or polished to a thickness of 20 µm, to obtain a transparent SOI wafer.

No breakage was observed in the periphery of the obtained transparent SOI wafer. Even after heat-treating the transparent SOI wafer at 500°C for 6 hours, no breakage was observed.

### (Example 2)

A silicon wafer of 150 mm in diameter and 625 µm in thickness and a quartz wafer of the same size as the silicon wafer were bonded together, and heat-treated at 200°C for 24 hours. Following this, a green laser (SHG-YAG laser: λ = 515 nm) was applied to the boundary between a bonded surface portion bonded in the bonding step and an unbonded surface portion, to vertically cut off an unbonded portion. The silicon wafer of the bonded wafer after cutting was ground or polished to a thickness of 20 µm, to obtain a transparent SOI wafer.

No breakage was observed in the periphery of the obtained transparent SOI wafer. Even after heat-treating the transparent SOI wafer at 500°C for 6 hours, no breakage was observed.

### (Comparative Example 1)

A silicon wafer of 150 mm in diameter and 625 µm in thickness and a quartz wafer of the same size as the silicon wafer were bonded together, and heat-treated at 200°C for 24 hours. Following this, the silicon wafer of the obtained bonded wafer was ground or polished to a thickness of 20 µm, to obtain a transparent SOI wafer.

A breakage was observed in the periphery of the obtained transparent SOI wafer.

### (Example 3)

A transparent SOI wafer was formed in the same manner as in Example 1, except that a sapphire wafer was used as the transparent handle wafer.

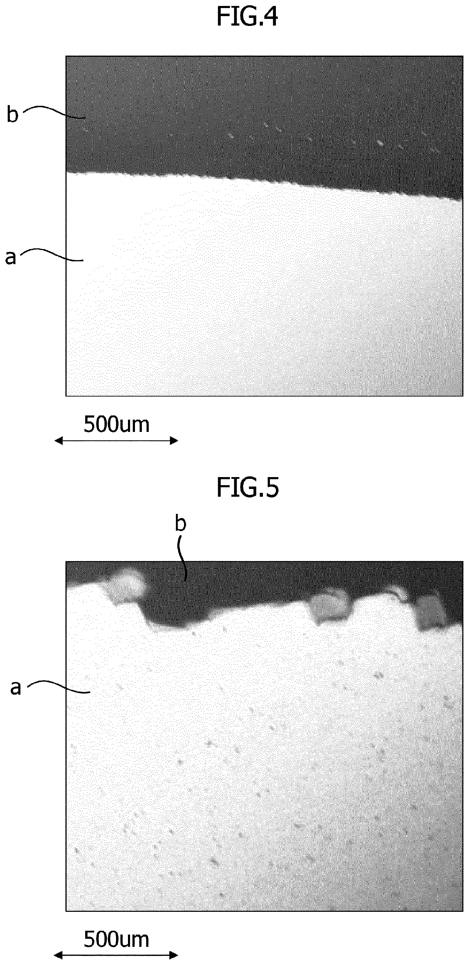

FIG. 4 shows an enlarged photograph of the periphery of the obtained transparent SOI wafer. No breakage was observed in the boundary (periphery) between a silicon film "a" and a sapphire wafer "b", as shown in FIG. 4. Even after heat-treating the transparent SOI wafer at 500°C for 6 hours, no breakage was observed.

### (Comparative Example 2)

A transparent SOI wafer was formed in the same manner as in Comparative Example 1, except that a sapphire wafer was used as the transparent handle wafer.

FIG. 5 shows an enlarged photograph of the periphery of the obtained transparent SOI wafer. A breakage was observed in the boundary (periphery) between a silicon film a and a sapphire wafer b, as shown in FIG. 5.

### (Example 4)

A surface of a silicon wafer of 150 mm in diameter and 625 µm in thickness and a surface of a sapphire wafer of the same size as the silicon wafer were plasma-treated, as a surface activation treatment. The plasma-treated surfaces of the silicon wafer and the sapphire wafer were then bonded together, and heat-treated at 150°C for 24 hours. Following this, the silicon wafer of the obtained bonded wafer was ground or polished to a thickness of 200 µm. A green laser (SHG-YAG laser: λ = 515 nm) was applied to the boundary between a bonded surface portion bonded in the bonding step and an unbonded surface portion, to vertically cut off an unbonded portion. Subsequently, the silicon wafer was ground or polished to a thickness of 20 µm, to obtain a transparent SOI wafer.

No breakage was observed in the periphery of the obtained transparent SOI wafer. Even after heat-treating the transparent SOI wafer at 500°C for 6 hours, no breakage was observed.

### Description of reference numerals

11: transparent handle wafer, 11s: surface, 12: silicon wafer, 12s: surface, 12B, 22B: silicon film, 13: bonded wafer, 14, 24: bonded surface portion, 15, 25: unbonded portion, 15a, 25a: unbonded surface portion, 16, 26: boundary, 17, 27: bonded wafer, 18, 28: transparent SOI wafer, 101: handle wafer, 102: donor wafer, 102a: cross section of periphery of donor wafer, 102b: breakage, C: center, θ: angle, α: angle, H₁, H₂: heat treatment, L: visible light laser, a: silicon film, b: sapphire wafer

## Claims

1. A method for producing a transparent SOI wafer, the method comprising the steps of:
bonding a surface of a silicon wafer used as a donor wafer and a surface of a transparent handle wafer together to obtain a bonded wafer;
heat-treating the bonded wafer at a first temperature of 150 to 300°C as a first heat treatment;
cutting off an unbonded portion of the bonded wafer along a boundary between the bonded surface and an unbonded circumferential surface by irradiating a visible light laser from a silicon wafer side of the heated bonded wafer to the boundary, while keeping an angle of 60 to 90° between an incident light of the laser and a radial direction of the silicon wafer;
subjecting the silicon wafer of the bonded wafer having the unbonded portion cut off to grinding, polishing, or etching to form a silicon film; and
heat-treating the bonded wafer having the silicon film formed at a second temperature of 300 to 500°C as a second heat treatment which is higher than the first temperature, wherein
in the step of bonding, a peripheral portion of the silicon wafer before being bonded is chamfered, or the silicon wafer before being bonded is larger in diameter than the transparent handle wafer.

2. The method for producing a transparent SOI wafer according to Claim 1, wherein the second temperature is 150 to 250°C higher than the first temperature.

3. The method for producing a transparent SOI wafer according to Claim 1 or 2,
further comprising, after the step of bonding and before the step of cutting off, a step of subjecting the silicon wafer of the bonded wafer to grinding, polishing or etching to have a thickness of greater than or equal to 100 µm, and
wherein the silicon film formed in the step of subjecting after the step of cutting off has a thickness of less than or equal to 20 µm.

4. The method for producing a transparent SOI wafer according to any one of Claims 1 to 3, wherein the visible light laser is a SHG-YAG laser.

5. The method for producing a transparent SOI wafer according to any one of Claims 1 to 4, wherein the transparent handle wafer is of quartz, glass, or sapphire.

6. The method for producing a transparent SOI wafer according to any one of Claims 1 to 5, wherein:
when the transparent handle wafer is of quartz or glass, the first temperature is from 150 to 300°C and the second temperature is from 350 to 500°C; and
when the transparent handle wafer is of sapphire, the first temperature is from 150 to 250°C and the second temperature is from 300 to 500°C.

7. The method for producing a transparent SOI wafer according to any one of Claims 1 to 6, further comprising, before the step of bonding, a step of performing a surface activation treatment on either or both of the surface of the silicon wafer and the surface of the transparent handle wafer.

8. The method for producing a transparent SOI wafer according to Claim 7, wherein the surface activation treatment is at least one selected from the group consisting of an ozone water treatment, an UV ozone treatment, an ion beam treatment and a plasma treatment.

9. The method for producing a transparent SOI wafer according to any one of Claims 1 to 8, wherein the silicon wafer used as the donor wafer is a silicon wafer having an oxide film thereon.

## Patentansprüche

1. Verfahren zur Herstellung eines transparenten SOI-Wafers, wobei das Verfahren die Schritte umfasst:
Binden einer Oberfläche eines Silicium-Wafers, der als Donor-Wafer verwendet wird, und einer Oberfläche eines transparenten Handle-Wafers aneinander um einen verbundenen Wafer zu erhalten;
Hitze-Behandeln des verbundenen Wafers bei einer ersten Temperatur von 150 bis 300 °C als erste Hitze-Behandlung;
Abschneiden eines ungebundenen Bereichs des verbundenen Wafers entlang einer Grenze zwischen der gebundenen Oberfläche und einer ungebundenen umlaufenden Oberfläche durch Einstrahlen eines sichtbaren Licht-Lasers von einer Silicium-Wafer-Seite des erhitzten verbundenen Wafers auf die Grenze, wobei ein Winkel von 60 bis 90° zwischen einem einfallenden Licht des Lasers und einer radialen Richtung des Silicium-Wafers eingehalten wird;
Unterziehen des Silicium-Wafers des verbundenen Wafers, bei dem der ungebundene Bereich abgeschnitten ist, dem Schleifen, Polieren oder Ätzen, um einen Siliciumfilm zu bilden; und
Hitze-Behandeln des verbundenen Wafers mit dem gebildeten Siliciumfilm bei einer zweiten Temperatur von 300 bis 500 °C als eine zweite Hitze-Behandlung, welche höher ist als die erste Temperatur, wobei
in dem Bindeschritt ein peripherer Bereich des Silicium-Wafers, bevor er gebunden ist, abgefräst wird oder der Silicium-Wafer, bevor er gebunden ist, größer im Durchschnitt ist als der transparente Handle-Wafer.

2. Verfahren zur Herstellung eines transparenten SOI-Wafers nach Anspruch 1, wobei die zweite Temperatur 150 bis 250 °C höher ist als die erste Temperatur.

3. Verfahren zur Herstellung eines transparenten SOI-Wafers nach Anspruch 1 oder 2, weiter umfassend,
nach dem Bindeschritt und vor dem Schritt des Abschneidens, einen Schritt des Unterziehens des Silicium-Wafers des gebundenen Wafers dem Schleifen, Polieren oder Ätzen, um eine Dicke von größer oder gleich 100 µm zu haben, und
wobei der Siliciumfilm, der in dem Schritt des Unterziehens nach dem Schritt des Abschneidens gebildet wird, eine Dicke von weniger oder gleich 20 µm hat.

4. Verfahren zur Herstellung eines transparenten SOI-Wafers nach einem der Ansprüche 1 bis 3,
wobei der sichtbare Licht-Laser ein SHG-YAG-Laser ist.

5. Verfahren zur Herstellung eines transparenten SOI-Wafers nach einem der Ansprüche 1 bis 4,
wobei der transparente Handle-Wafer aus Quarz, Glas oder Saphir ist.

6. Verfahren zur Herstellung eines transparenten SOI-Wafers nach einem der Ansprüche 1 bis 5, wobei:
wenn der transparente Handle-Wafer aus Quarz oder Glas ist, die erste Temperatur von 150 bis 300 °C ist und die zweite Temperatur von 350 bis 500 °C ist; und
wenn der transparente Handle-Wafer aus Saphir ist, die erste Temperatur von 150 bis 250 °C ist und die zweite Temperatur von 300 bis 500 °C ist.

7. Verfahren zur Herstellung eines transparenten SOI-Wafers nach einem der Ansprüche 1 bis 6, weiter umfassend, vor dem Bindeschritt, einen Schritt der Durchführung einer Oberflächenaktivierungs-Behandlung auf einer oder beiden der Oberfläche des Silicium-Wafers und der Oberfläche des transparenten Handle-Wafers.

8. Verfahren zur Herstellung eines transparenten SOI-Wafers nach Anspruch 7,
wobei die Oberflächenaktivierungs-Behandlung wenigstens eine ausgewählt aus der Gruppe bestehend aus einer Ozon-Wasser-Behandlung, einer UV-Ozon-Behandlung, einer Ionenstrahl-Behandlung und einer Plasma-Behandlung ist.

9. Verfahren zur Herstellung eines transparenten SOI-Wafers nach einem der Ansprüche 1 bis 8,
wobei der Silicium-Wafer, der als Donor-Wafer verwendet wird, ein Silicium-Wafer mit einem Oxidfilm darauf ist.

## Revendications

1. Procédé de production d'une tranche de silicium sur isolant transparente, le procédé comprenant les étapes de :
liaison d'une surface d'une tranche de silicium utilisée comme tranche donneuse d'avec une surface d'une tranche de manipulation transparente pour obtenir une tranche liée ;
traitement à la chaleur de la tranche liée à une première température de 150 à 300 °C en tant que premier traitement à la chaleur ;
découpage d'une portion non liée de la tranche liée le long d'une bordure entre la surface liée et une surface circonférentielle non liée par irradiation d'un laser de lumière visible du côté tranche de silicium de la tranche liée chauffée à la frontière, tout en gardant un angle de 60 à 90° entre une lumière incidente du laser et une direction radiale de la tranche de silicium ;
soumission de la tranche de silicium de la tranche liée ayant la découpe de portion non liée à un meulage, un polissage, ou une gravure pour former un film de silicium ; et
traitement à la chaleur de la tranche liée comportant le film de silicium formé à une seconde température de 300 à 500 °C en tant que second traitement à la chaleur, ladite seconde température étant supérieure à la première température ;
dans lequel
dans l'étape de liaison, une portion périphérique de la tranche de silicium avant d'être liée est chanfreinée, ou bien la tranche de silicium avant d'être liée est de plus grand diamètre que la tranche de manipulation transparente.

2. Procédé de production d'une tranche de silicium sur isolant transparente selon la revendication 1, dans lequel la seconde température est de 150 à 250 °C plus élevée que la première température.

3. Procédé de production d'une tranche de silicium sur isolant transparente selon la revendication 1 ou 2,
comprenant en outre, après l'étape de liaison et avant l'étape de découpe, une étape de soumission de la tranche de silicium de la tranche liée à un meulage, un polissage ou une gravure pour qu'elle ait une épaisseur supérieure ou égale à 100 µm, et
dans lequel le film de silicium formé dans l'étape de soumission après l'étape de découpe a une épaisseur inférieure ou égale à 20 µm.

4. Procédé de production d'une tranche de silicium sur isolant transparente selon l'une quelconque des revendications 1 à 3, dans lequel le laser de lumière visible est un laser SHG-YAG.

5. Procédé de production d'une tranche de silicium sur isolant transparente selon l'une quelconque des revendications 1 à 4, dans lequel la tranche de manipulation transparente est en quartz, en verre, ou en saphir.

6. Procédé de production d'une tranche de silicium sur isolant transparente selon l'une quelconque des revendications 1 à 5, dans lequel :
lorsque la tranche de manipulation transparente est en quartz ou en verre, la première température est de 150 à 300 °C et la seconde température est de 350 à 500 °C ; et
lorsque la tranche de manipulation transparente est en saphir, la première température est de 150 à 250 °C et la seconde température est de 300 à 500 °C.

7. Procédé de production d'une tranche de silicium sur isolant transparente selon l'une quelconque des revendications 1 à 6, comprenant en outre, avant l'étape de liaison, une étape de réalisation d'un traitement d'activation de surface sur la surface de la tranche de silicium et/ou la surface de la tranche de manipulation transparente.

8. Procédé de production d'une tranche de silicium sur isolant transparente selon la revendication 7, dans lequel le traitement d'activation de surface est au moins un élément choisi dans le groupe consistant en un traitement à l'eau ozonisée, un traitement aux UV-ozone, un traitement par faisceau d'ions et un traitement au plasma.

9. Procédé de production d'une tranche de silicium sur isolant transparente selon l'une quelconque des revendications 1 à 8, dans lequel la tranche de silicium utilisée comme tranche donneuse est une tranche de silicium comportant un film d'oxyde dessus.
